# EUROPÄISCHE PATENTSCHRIFT

(11) **EP 1 895 824 B1**
(45) Veröffentlichungstag und Bekanntmachung des Hinweises auf die Patenterteilung: **01.04.2009**
(21) Anmeldenummer: 06018133.6
(22) Anmeldetag: 30.08.2006
(51) Int. Cl.: H05K 7/20

(54) **Baugruppe für ein Automatisierungsgerät**
Assembly for an automation device
Assemblage pour un appareil d'automatisation

(43) Veröffentlichungstag der Anmeldung: 05.03.2008
(73) Patentinhaber: SIEMENS AKTIENGESELLSCHAFT, 80333 München (DE)
(72) Erfinder: Abert, Michael, 76474 Au (DE)

(56) Entgegenhaltungen:
- EP-A2- 0 681 421
- DE-A1- 2 015 361
- US-A1- 2004 105 036
- US-A1- 2005 099 771

## Beschreibung

Die Erfindung betrifft eine Baugruppe für ein aus mehreren benachbarten Baugruppen bestehendes Automatisierungsgerät, mit einer Gehäusekapsel, welche wenigstens eine Rückwand und zwei Seitenwände aufweist und welche zur Aufnahme von elektrischen Komponenten vorgesehen ist. Darüber hinaus betrifft die Erfindung ein Automatisierungsgerät mit derartigen Baugruppen.

Eine Baugruppe gemäß dem Oberbegriff des Anspruchs 1 ist aus dem Siemens-Katalog "ST 70 News 2006, SIMATIC S7, Kapitel 3" bekannt. Innerhalb einer Gehäusekapsel der Baugruppe ist eine mit elektrischen und elektronischen Bauteilen versehene Leiterplatte angeordnet. Die Entwärmung dieser Bauteile erfolgt im Wesentlichen durch Konvektion in der Art und Weise, dass Luft durch eine Öffnung auf der Unterseite der Gehäusekapsel über die Bauteile und schließlich durch eine Öffnung auf der Oberseite der Gehäusekapsel strömt, wobei die durch das Gehäuse strömende Luft den Bauteilen Wärme entzieht. Diese Öffnungen in der Gehäusekapsel unter- und oberhalb der Bauteile sind insbesondere im Hinblick auf einen Einsatz der Baugruppen bzw. des Automatisierungsgerätes in explosionsgefährdeten Bereichen oder in Anwendungen, die Dichtigkeit erfordern, störend. Darüber hinaus erwärmen sich benachbarte Baugruppen des Automatisierungsgerätes gegenseitig, was im Rahmen einer Projektierung des Automatisierungsgerätes berücksichtigt werden muss und aufgrund der Kombinationsvielfalt des modularen Automatisierungsgerätes die Projektierung erschwert.

Der vorliegenden Erfindung liegt die Aufgabe zugrunde, eine Baugruppe der eingangs genannten Art mit einer verbesserten Wärmeableitung zu schaffen. Darüber hinaus ist ein Automatisierungsgerät mit einer verbesserten Wärmeableitung anzugeben.

Diese Aufgabe wird im Hinblick auf die Baugruppe dadurch gelöst, dass eine der Seitenwände thermisch leitfähig und die andere Seitenwand thermisch isoliert ausgebildet ist. Im Hinblick auf das Automatisierungsgerät wird diese Aufgabe durch die im Anspruch 4 angegebenen Maßnahmen gelöst.

Vorteilhaft ist, dass auf die Öffnungen in der Gehäusekapsel unterhalb der elektrischen und elektronischen Bauteile verzichtet werden kann und dadurch eine geschlossene Bauform ermöglicht wird. Die thermisch leitfähig ausgebildete Seitenwand ist zur Wärmeabfuhr der Baugruppe vorgesehen, die thermisch isoliert ausgebildete Seitenwand verhindert eine thermische Kopplung mit einer benachbarten Baugruppe eines zusammengebauten Automatisierungsgerätes. Dadurch, dass eine thermische Kopplung der Baugruppen verhindert wird, erwärmen sich benachbarte Baugruppen nicht gegenseitig.

In einer Ausgestaltung der Erfindung ist die wärmeleitfähige Seitenwand im Wesentlichen u-förmig und/oder rippenartig ausgebildet, was eine Vergrößerung der Wärme abgebenden Seitenwandfläche bewirkt.

In einer weiteren Ausgestaltung der Erfindung ist vorgesehen, elektrische Komponenten der Baugruppe, z. B. eine mit elektronischen Bauelementen bestückte Leiterplatte, mit der thermisch leitfähigen Seitenwand thermisch zu koppeln. Dadurch wird die Entwärmung der Baugruppe weiter verbessert.

In einem Automatisierungsgerät mit derartigen Baugruppen, wobei jeweils die thermisch leitfähige Seitenwand einer Baugruppe zu der thermisch isolierten Seitenwand einer anderen Baugruppe benachbart ist, ist die Rippenhöhe bzw. die Breite (Kaminbreite) der jeweiligen thermisch leitfähigen Seitenwand an die Verlustleistung der jeweiligen Baugruppe angepasst. Die Rippenhöhe bzw. Kaminbreite von Baugruppen geringerer Verlustleistung sind im Vergleich zu Baugruppen höherer Verlustleistung geringer ausgebildet, wodurch bei Baugruppen gleicher Baugruppenbreite die Baugruppen mit geringer Verlustleistung mehr Raum für Funktionselemente aufweisen.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
Figur 1 ein modulares Automatisierungsgerät und
Figur 2 Querschnitte von thermisch leitfähigen Seitenwänden.

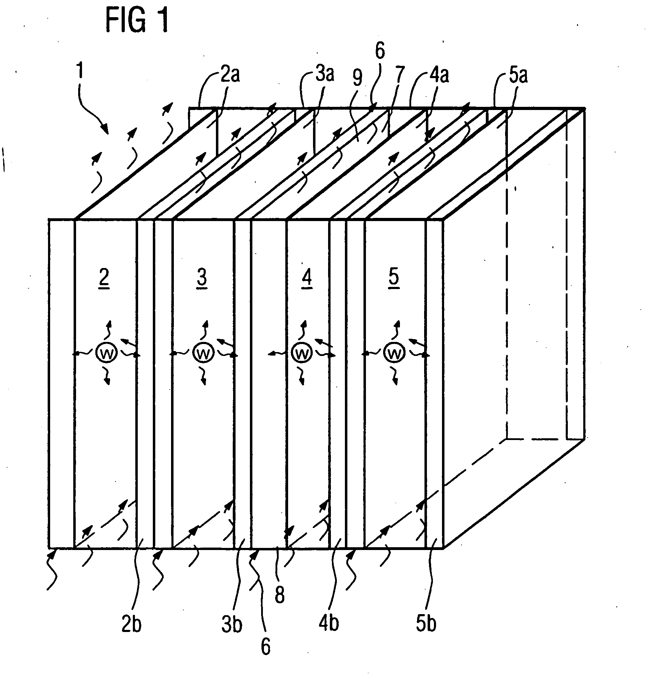

In Figur 1 ist mit 1 ein modulares Automatisierungsgerät bezeichnet, welches vier Baugruppen 2, 3, 4, 5 gleicher Baugruppenbreite umfasst. Weitere Bestandteile des Automatisierungsgeräts 1, z. B. Kommunikationsmittel, über welche die Baugruppen miteinander verbunden sind, oder geeignete Hakvorrichtungen zum Aufschwenken der Baugruppen auf eine hier nicht dargestellte Tragschiene, sind für die Erfindung ohne Bedeutung und werden im Folgenden nicht erläutert. Selbstverständlich können die Baugruppen unterschiedlich breit ausgebildet sein. Aus optischen bzw. Designgründen ist es allerdings vorteilhaft, die Breite der Baugruppen gleich oder in gleicher Modularität (Breite 2fach, 3fach, usw.) zu gestalten. Die Baugruppen 2, 3, 4, 5 weisen jeweils eine thermisch leitfähige u-förmige Seitenwand 2a, 3a, 4a, 5a sowie jeweils eine thermisch isolierte Seitenwand 2b, 3b, 4b, 5b auf, wobei jeweils eine thermisch isolierte Seitenwand 2b, 3b, 4b, 5b einer Baugruppe 2, 3, 4, 5 zu jeweils einer thermisch leitfähigen Seitenwand 2a, 3a, 4a, 5a einer weiteren Baugruppe 2, 3, 4, 5 benachbart ist.
Im vorliegenden Beispiel ist angenommen, dass die Baugruppe 4 während des Steuerbetriebs eine höhere Verlustleistung als die Baugruppen 2, 3, 5 erzeugt, was bedeutet, dass der Baugruppe 4 mehr Wärme als den Baugruppen 2, 3, 5 entzogen werden muss. Dazu ist die thermisch leitfähige Seitenwand 4a der Baugruppe 4 breiter ausgebildet als die thermisch leitfähigen Seitenwände 2a, 3a, 5a der Baugruppen 2, 3, 5. Die Breite der thermisch isolierten Seitenwände 2b, 3b, 4b, 5b ist für alle Baugruppen 2, 3, 4, 5 gleich, wodurch an diesen Wänden die Wärmeverhältnisse im Wesentlichen identisch sind. Die Entwärmung der Baugruppen 2, 3, 4, 5 erfolgt im Wesentlichen durch thermische Konvektion. Dazu strömt Luft 6 z. B. durch einen von der thermisch isolierten Seitenwand 3b der Baugruppe 3 und der thermisch leitfähigen Seitenwand 4a der Baugruppe 4 gebildeten "Kamin" 7 von einem Kamineintritt 8 zu einem Kaminaustritt 9, wobei die Luft 6 der thermisch leitfähigen Seitenwand 4a der Baugruppe 4 Wärme entzieht.

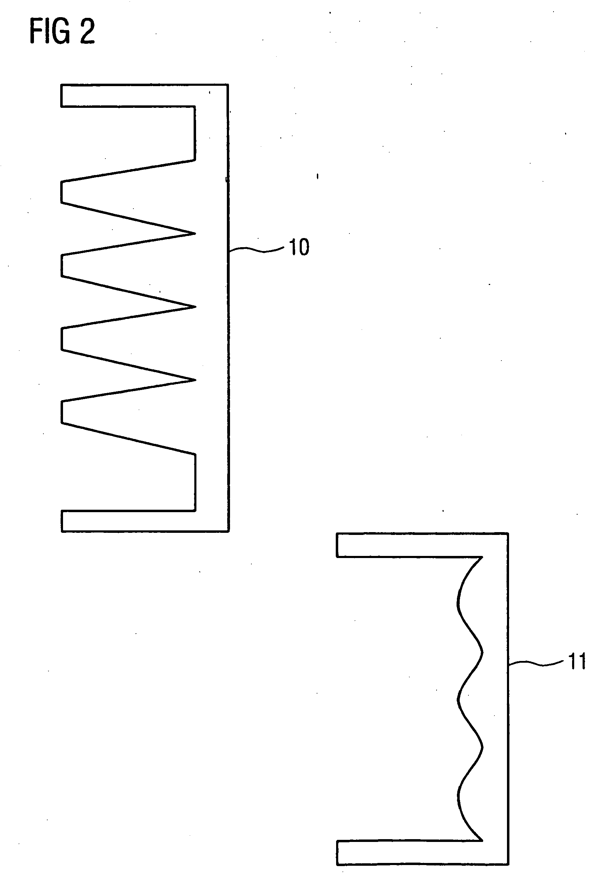

Um die Oberfläche einer thermisch leitfähigen Seitenwand zu vergrößern, ist eine Seitenwand 10 (Figur 2) zumindest teilweise rippenförmig und eine weitere Seitenwand 11 wellenförmig ausgebildet. Derartige Maßnahmen vergrößern die Wärme abgebende Seitenwandfläche, wodurch die Entwärmung einer Baugruppe verbessert wird.
Die beschriebenen Anordnungen und Ausgestaltungen der Baugruppen ergeben auch dann Vorteile bei der Entwärmung, wenn diese nicht durch natürliche Konvektion sondern durch Zwangsbelüftung erfolgt, z. B. in der Art und Weise, dass durch unterhalb der Baugruppen angeordnete Lüfter eine Belüftung bewirkt wird.

## Patentansprüche

1. Baugruppe für ein aus mehreren benachbarten Baugruppen (2, 3, 4, 5) bestehendes Automatisierungsgerät (1), mit einer Gehäusekapsel, welche wenigstens eine Rückwand und zwei Seitenwände (2a, 3a, 4a, 5a; 2b, 3b, 4b, 5b) aufweist und welche zur Aufnahme von elektrischen Komponenten vorgesehen ist, **dadurch gekennzeichnet, dass** eine der Seitenwände (2a, 3a, 4a, 5a) thermisch leitfähig und die andere Seitenwind (2b, 3b, 4b, 5b) thermisch isoliert ausgebildet ist.

2. Baugruppe nach Anspruch 1, **dadurch gekennzeichnet, dass** die thermisch leitfähige Seitenwand (2a, 3a, 4a, 5a) im Wesentlichen u-förmig und/oder rippenartig ausgebildet ist.

3. Baugruppe nach Anspruch 1 oder 2, **dadurch gekennzeichnet, dass** die elektrischen Komponenten mit der thermisch leitfähigen Seitenwand (2a, 3a, 4a, 5a) thermisch gekoppelt sind.

4. Automatisierungsgerät mit mehreren benachbarten Baugruppen nach einem der Ansprüche 1 bis 3, wobei jeweils die thermisch leitfähige Seitenwand (2a, 3a, 4a, 5a) einer Baugruppe zu der thermisch isolierten Seitenwand (2b, 3b, 4b, 5b) einer anderen Baugruppe benachbart ist.

5. Automatisierungsgerät nach Anspruch 4, welches durch mindestens einen Lüfter zwangsbelüftet wird.

## Claims

1. Module for an automation device (1) consisting of a plurality of adjacent modules (2, 3, 4, 5), having a housing capsule that has at least one rear wall and two side walls (2a, 3a, 4a, 5a; 2b, 3b, 4b, 5b) and which is provided for housing electric components, **characterised in that** one of the side walls (2a, 3a, 4a, 5a) is embodied as being thermally conductive and the other side wall (2b, 3b, 4b, 5b) as being thermally insulated.

2. Module according to claim 1 **characterised in that** the thermally conductive side wall (2a, 3a, 4a, 5a) is embodied as being substantially u-shaped and/or in the form of ribs.

3. Module according to claim 1 or 2 **characterised in that** the electric components are thermally coupled to the thermally conductive side wall (2a, 3a, 4a, 5a).

4. Automation device having a plurality of adjacent modules according to one of claims 1 to 3, with in each case the thermally conductive side wall (2a, 3a, 4a, 5a) of one module being adjacent to the thermally insulated side wall (2b, 3b, 4b, 5b) of another module.

5. Automation device according to claim 4 that is forced-ventilated by at least one ventilator.

## Revendications

1. Module destiné à un appareil d'automatisation (1), composé de plusieurs modules (2, 3, 4, 5) voisins, et équipé d'une capsule de boîtier, qui comporte au moins une paroi arrière et deux parois latérales (2a, 3a, 4a, 5a ; 2b, 3b, 4b, 5b) et qui est prévu pour recevoir des composants électriques, **caractérisé en ce qu'**une des parois latérales (2a, 3a, 4a, 5a) est susceptible de conduire la chaleur et l'autre paroi latérale (2b, 3b, 4b, 5b) isole de la chaleur.

2. Module selon la revendication 1, **caractérisé en ce que** la paroi latérale (2a, 3a, 4a, 5a) susceptible de conduire la chaleur a pratiquement une forme en U et/ou présente des nervures.

3. Module selon la revendication 1 ou 2, **caractérisé en ce que** les composants électriques sont en couplage thermique avec la paroi latérale (2a, 3a, 4a, 5a) susceptible de conduire la chaleur.

4. Appareil d'automatisation comportant plusieurs modules voisins selon l'une des revendications 1 à 3, dans lequel chaque paroi latérale (2a, 3a, 4a, 5a) susceptible de conduire la chaleur d'un module est voisine de la paroi latérale (2b, 3b, 4b, 5b) isolant de la chaleur d'un autre module.

5. Appareil d'automatisation selon la revendication 4 ventilé de façon forcée par au moins un ventilateur.
